**Europäisches Patentamt**

**European Patent Office**

**Office européen des brevets**

(19)

(11) Veröffentlichungsnummer: **0 077 902**
**B1**

(12) **EUROPÄISCHE PATENTSCHRIFT**

(45) Veröffentlichungstag der Patentschrift:
14.06.89

(51) Int. Cl.⁴: **H 01 L 27/02, H 03 K 19/091**

(21) Anmeldenummer: 82108134.6

(22) Anmeldetag: 03.09.82

(54) **Bipolar integrierte Inverstransistorlogik.**

(30) Priorität: 22.10.81 DE 3141932
19.02.82 DE 3205950

(43) Veröffentlichungstag der Anmeldung:
04.05.83 Patentblatt 83/18

(45) Bekanntmachung des Hinweises auf die Patenterteilung:
14.06.89 Patentblatt 89/24

(84) Benannte Vertragsstaaten:
DE FR GB IT

(73) Patentinhaber: ROBERT BOSCH GMBH, Postfach 50,
D-7000 Stuttgart 1 (DE)

(72) Erfinder: Fleischer, Ulrich, Dr. Dipl.-Ing.,
Büttensülzerweg 16, D-7401 Pliezhausen (DE)
Erfinder: Conzelmann, Gerhard, Dipl.-Phys.,
Wilhemstrasse 37, D-7022 Leinfelden (DE)

(56) Entgegenhaltungen:
IEEE JOURNAL OF SOLID-STATE CIRCUITS, Band
SC-11, Nr. 3, Juni 1976, Seiten 379-385, New York, US; C.
MULDER u.a.: "High speed integrated injection logic
(I2L)"
IDEM
IEEE INTERNATIONAL ELECTRON DEVICES MEETING,
TECHNICAL DIGEST, Washington, 6.-8. Dezember 1976,
Seiten 299-303, IEEE, New York, US; F.M. KLAASSEN:
"Physics of and models for I2L"
IEEE JOURNAL OF SOLID-STATE CIRCUITS, Band
SC-12, Nr. 5, Oktober 1977 Seiten 463-472, New York,
US; T. TICH DAO: "Threshold I2L and its applications to
binary symmetric functions and multivalued logic"
RADIO FERNSEHEN ELEKTRONIK, Band 27, Nr. 10,
Oktober 1978, Seiten 621-625; H.-E. KRÖBEL:

(56) Entgegenhaltungen: (Fortsetzung)
"Grundschaltungen der analogen integrierten Technik"
SOLID STATE TECHNOLOGY, Band 20, Nr. 6, Juni 1977,
Seiten 42-48; J.L. STONE: "I2L: A comprehensive
review of techniques and technology"

## Beschreibung

Stand der Technik

Die Erfindung geht aus von einer bipolar integrierten Inverstransistorlogik nach der Gattung des Hauptanspruchs.

Aus dem «Fairchild Journal of Semiconductor Progress», Band 8, Nr. 2 (März/April 1980) ist bereits eine bipolar integrierte Inverstransistorlogik – im folgenden auch kurz mit ITL-Schaltung oder mit ITL-Struktur bezeichnet – mit mindestens einem vertikal aufwärts verstärkenden Gattertransistor und mindestens einem von diesem räumlich getrennten lateralen Stromquellentransistor bekannt, der einen zum Gattertransistor entgegengesetzten Leitungstyp und mindestens einen Kollektor hat, der an die Basis des Gattertransistors angeschlossen ist. Bei dieser bekannten ITL-Schaltung ist die Basis des lateralen Stromquellentransistors und der Emitter des vertikal aufwärts verstärkenden Gattertransistors auf dasselbe Potential (Massepotential) gelegt, womit auch der im Betrieb der Gatter auftretende Sättigungszustand des Injektorteils (hier separater Lateraltransistor) in $I^2L$-üblicher Weise unvermeidbar und mit allen Nachteilen auf das Gatterverhalten bestehen bleibt. Immerhin ist die örtliche Trennung von Injektorteil und Verstärkertransistor vollzogen, was man im Sinne der merged transistor logic eigentlich immer als einen Nachteil bezüglich Flächenaufwand verstanden hat. Damit entfällt eigentlich auch schon die Berechtigung für die Bezeichnung «Injektionslogik», denn der direkt in die Basis des Verstärkertransistors injizierte Ansteuerstrom existiert als solcher nicht mehr. Er ist ersetzt durch einen Ansteuerstrom, der einem körperlich vorhandenen separaten Lateralkollektor eines Stromquellentransistors entnommen wird und über eine metallisch leitende Verbindung der Basis des Verstärkertransistors zugeführt wird.

Aus dem «IEEE Journal of Solid-State Circuits», Band SC-11, Nr. 3, Juni 1976, Seiten 379 bis 385, ist ferner bereits eine bipolar integrierte Inversistorlogik nach der Gattung des Hauptanspruchs bekannt. Die Potentialtrennung zwischen der Basis des lateralen Stromquellentransistors und dem Emitter des vertikal aufwärts verstärkenden Gattertransistors erfolgt bei dieser bekannten ITL-Schaltung mit Hilfe einer Diode, die parallel zur Emitter-Basis-Strecke des Gattertransistors angeordnet ist. Mit einer derartigen Anordnung einer Diode läßt sich zwar das Basispotential des lateralen Stromquellentransistors so einstellen, daß dieser Transistor auch bei leitendem Gattertransistor nicht mehr im Sättigungsbetrieb arbeitet, so daß damit die volle Stromverstärkung des vertikal aufwärts verstärkenden Gattertransistors als Gatterstromverstärkung zur Verfügung steht. Diese bekannte ITL-Schaltung hat jedoch den Nachteil, daß der Arbeitsstrom für den vertikal aufwärts verstärkenden Gattertransistor nicht mit hinreichender Genauigkeit bereitgestellt werden kann. Dieser Nachteil fällt insbesondere dann besonders stark ins Gewicht, wenn in einer integrierten Schaltung eine Vielzahl von Gattertransistoren vorgesehen ist, die in ihrer Gesamtheit eine hohe Genauigkeit und Gleichmäßigkeit aller Arbeitsströme erfordert.

Vorteile der Erfindung

Die erfindungsgemäße bipolar integrierte Inverstransistorlogik mit den kennzeichnenden Merkmalen des Hauptanspruchs hat demgegenüber den Vorteil, daß der Arbeitsstrom für den vertikal aufwärts verstärkenden Gattertransistor mit hoher Genauigkeit bereitgestellt wird. Ist eine integrierte Schaltung mit einer Vielzahl von Gattertransistoren vorgesehen, so wird für die Gesamtheit aller Gattertransistoren eine hohe Genauigkeit und Gleichmäßigkeit aller Arbeitsströme erzielt. Weitere Vorteile ergeben sich aus den Unteransprüchen 2 bis 22 und aus der Beschreibung.

Zeichnung

Ausführungsbeispiele der erfindungsgemäßen bipolar integrierten Inverstransistorlogik sind in der Zeichnung dargestellt und in der nachfolgenden Beschreibung näher erläutert. Es zeigen:

Figur 1a eine Draufsicht auf eine bekannte $I^3L$-Struktur in schematischer Darstellung,

Figur 1b einen Schnitt nach der Linie AB der Figur 1a,

Figur 1c die elektrischen Ersatzbilder des $I^2L$-Teils und des Analogteils der in den Figuren 1a und 1b dargestellten $I^3L$-Struktur,

Figur 2 die Ausgangskennlinie des pnp-Injektionstransistors bzw. des pnp-Stromquellentransistors der bekannten $I^2L$- bzw. ITL-Struktur,

Figur 3 eine schematisierte Draufsicht auf ein Lay-Out einer bekannten $I^2L$- bzw. $I^3L$-Schaltung,

Figur 4a das elektrische Ersatzbild einer bekannten Inverstransistorlogik, bei der das Basispotential des lateralen pnp-Stromquellentransistors durch eine Spannungsquelle über dem Bezugspotential festgelegt ist,

Figur 4b eine Schaltung wie in Figur 4a, bei der die Spannungsquelle durch einen npn-Transistor mit Kurzschluß zwischen Basis und Kollektor gebildet ist,

Figur 4c eine Schaltung wie in Figur 4b, jedoch mit zwei npn-Gattertransistoren und mit einem mit drei Kollektoren versehenen lateralen pnp-Stromquellentransistor, wobei zwei dieser Kollektoren die Arbeitsströme für die beiden Gattertransistoren liefern und der dritte dieser Kollektoren an die kurzgeschlossene Basis-Kollektor-Strecke des als Spannungsquelle dienenden npn-Transistors angeschlossen ist,

Figur 4d die Schaltung nach Figur 4c in vereinfachter symbolischer Darstellung,

Figur 4e das elektrische Ersatzbild eines Ausführungsbeispiels einer erfindungsgemäßen Inverstransistorlogik,

Figur 4f bis 4k weitere erfindungsgemäße Schaltungsvarianten ähnlich der der Figur 4e,

Figur 5 die Struktur der ITL-Schaltung nach Figur 4b zusammen mit einem sich daran anschließenden Analogteil im Schnitt,

Figur 6 ein vereinfachtes Lay-Out einer vierstufigen asynchronen Frequenzteilerstufe,

Figur 7 das formale Lay-Out der Frequenzteilerstufe nach Figur 6.

Beschreibung der Erfindung

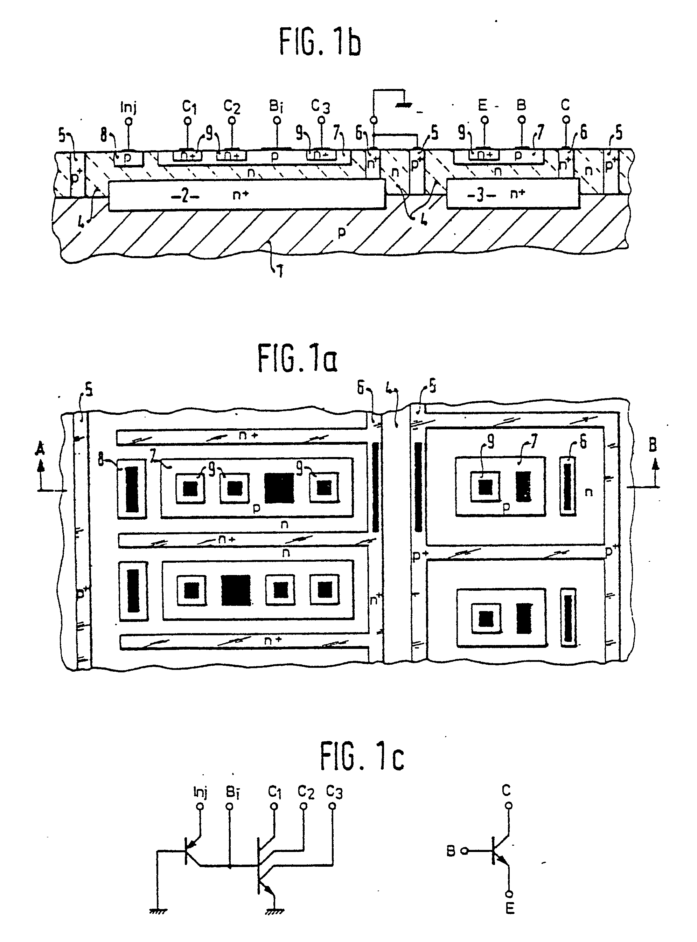

Die Figuren 1a und 1b zeigen schematisiert und ohne Anspruch auf maßstäbliche Genauigkeit einen gegriffenen Ausschnitt aus einer Struktur in konventioneller «Mischtechnik». Figur 1a ist die Draufsicht, Figur 1b ist die in Figur 1a gekennzeichnete Schnittansicht, Figur 1c zeigt die elektrischen Ersatzbilder der in den Figuren 1a und 1b dargestellten Strukturen – links ein $I^2L$-Gatter, rechts einen bipolaren Vertikaltransistor (hier vom npn-Typ).

Der Begriff «Mischtechnik» sagt aus, daß auf demselben Chip sowohl die vorwiegend für analoge Schaltungen geeigneten bipolaren Bauelemente (hier vertikaler npn-Transistor) als auch die für digitale Schaltungen geeigneten $I^2L$- bzw. $I^3L$-Gatter monolithisch integriert vorkommen. Bei der Mischtechnik geht man meist von einem Herstellungsprozeß aus, der die umfangreicheren und technisch schwierigeren Anforderungen an die Eigenschaften der Analog-Bauelemente befriedigt, und versucht, mit möglichst geringfügigen und die Eigenschaften der Analog-Bauelemente nicht negativ beeinflussenden Prozeßvarianten auch die Anforderungen an die Eigenschaften der digitalen Gatter zu erfüllen. In der Literatur sind zahlreiche Vorschläge für solche Prozeßvarianten bekanntgeworden, von denen aber zur Zeit nur sehr wenige auf dem Wege zu technisch-wirtschaftlicher Bedeutung sind. Für reine Digitalanwendungen gewinnt die $I^2L$-Technik zunehmend auch im LSI-Bereich an Bedeutung, weil bezüglich der Herstellungsprozesse die stark einschränkenden Forderungen für die Analog-Elemente hier entfallen und man damit die Prozeßergebnisse allein auf die $I^2L$-Eigenschaften optimieren kann.

Die Beschreibung von Struktur und elektrischem Verhalten erfolgt anhand der Mischtechnik-Struktur der Figur 1.

Die Erfindung bringt eine erhebliche Verbesserung der effektiven Gatterstromverstärkung. Die übrigen erfindungsgemäßen Vorteile sind: Verbesserte Gattergeschwindigkeit und ein weitgehend vorbereitetes Verdrahtungssystem, das diesbezügliche allgemeine Nachteile von $I^2L$- und $I^3L$-Schaltungen überwindet und die Verdrahtung für die Anwendung automatischer Entwurfsanlagen aufbereitet.

In Figur 1b ist das Schnittbild einer typischen Mischtechnik-Struktur schematisch dargestellt. Auf einem p-Substrat 1 wird nach Vorbelegung und Vordiffusion von später «vergrabenen» $n^+$-Gebieten 2, 3 eine schwach n-dotierte Schicht 4 epitaktisch aufgebracht. Mit den $p^+$-Diffusionen 5, die die elektrische Kontaktierung des p-Substrats 1 von der Halbleiteroberfläche her ermöglichen, wird die aktive Chipfläche so in Epitaxie-«Wannen» aufgeteilt, daß die Analog-Bauelemente – rechts in Figur 1a und Figur 1b – im wesentlichen je einzeln und die $I^2L$- bzw. $I^3L$-Gatter – links

in Figur 1a und Figur 1b – insgesamt in eine Wanne zu liegen kommen. Die $n^+$-Diffusionen 6 stellen die elektrische Verbindung der vergrabenen Schichten 2 und 3 zur Halbleiteroberfläche her und sorgen im $I^2L$- bzw. $I^3L$-Teil zusätzlich für die elektrische Abschirmung der Gatter gegeneinander. Im $I^2L$- bzw. $I^3L$-Teil wird zur Abschirmung der Gatter gegeneinander anstelle der $n^+$-Tiefdiffusion 6 mitunter aus Platzgründen die $n^+$-Flachdiffusion 9 verwendet. Die p-Diffusionen 7 bilden unter anderem sowohl im Analogteil als auch $I^2L$- bzw. $I^3L$-Teil die Basiszonen für die stromverstärkenden Transistoren. Im gleichen Diffusionsschritt entstehen auch die Injektorzonen 8 des Digitalteils. Im letzten Diffusionsschritt entstehen die flachen $n^+$-Zonen 9, die im Analogteil die Emitterzonen der vertikal abwärts arbeitenden npn-Transistoren und im Digitalteil die Kollektorzonen der vertikal aufwärts arbeitenden npn-Transistoren (mehrere Kollektoren pro Transistor) bilden. Die Kontaktfenster zur elektrischen Kontaktierung der einzelnen Zonen sind in der Draufsicht nach Figur 1a dunkel dargestellt. Auf Darstellung von Leiterbahnen wurde mit Rücksicht auf Übersichtlichkeit verzichtet.

Während der im Analogteil vertikal abwärts arbeitende npn-Transistor (9:Emitter – 7:Basis – 4, 3, 6:Kollektor) durch den so gewollten Aufbau der Struktur gute Stromverstärkung zeigt (typisch 100 bis 200), erreicht der vertikal aufwärts arbeitende npn-Transistor (6, 2, 4:Emitter – 7:Basis – 9:Kollektor) im Digitalteil nur mäßige Stromverstärkungen (typisch 3 bis 10 pro Kollektor) – zu verstehen bei jeweils günstigen Kollektorströmen, die für die beiden Transistoren unterschiedlich sind. Die Situation verschärft sich für den Aufwärtstransistor noch durch die Art seiner Ansteuerung über die laterale pnp-Injektionsstruktur (8:Emitter – 4:Basis – 7:Kollektor = Basis des Aufwärtstransistors). Dem elektrischen Ersatzbild des Gatters – Figur 1c links – entnimmt man sofort, daß der pnp-Injektionstransistor sättigt, sobald er den Aufwärtstransistor leitend steuert, der Injektionsstrom also nicht über den Basiskontakt $B_i$ und einen leitenden Kollektor eines zweiten Gatters extern abgeleitet wird. Das bedeutet aber, daß der Ansteuerstrom für den Aufwärtstransistor durch die sättigende Injektionsstruktur gerade dann verringert wird, wenn der Aufwärtstransistor diesen Strom zum Aufrechterhalten seines Leitungszustandes benögigt, und andererseits im Sperrzustand das sperrende Gatter mit dem vollen Injektionsstrom belastet wird, weil die Injektionsstruktur sich in diesem Fall nicht im Sättigungszustand befindet.

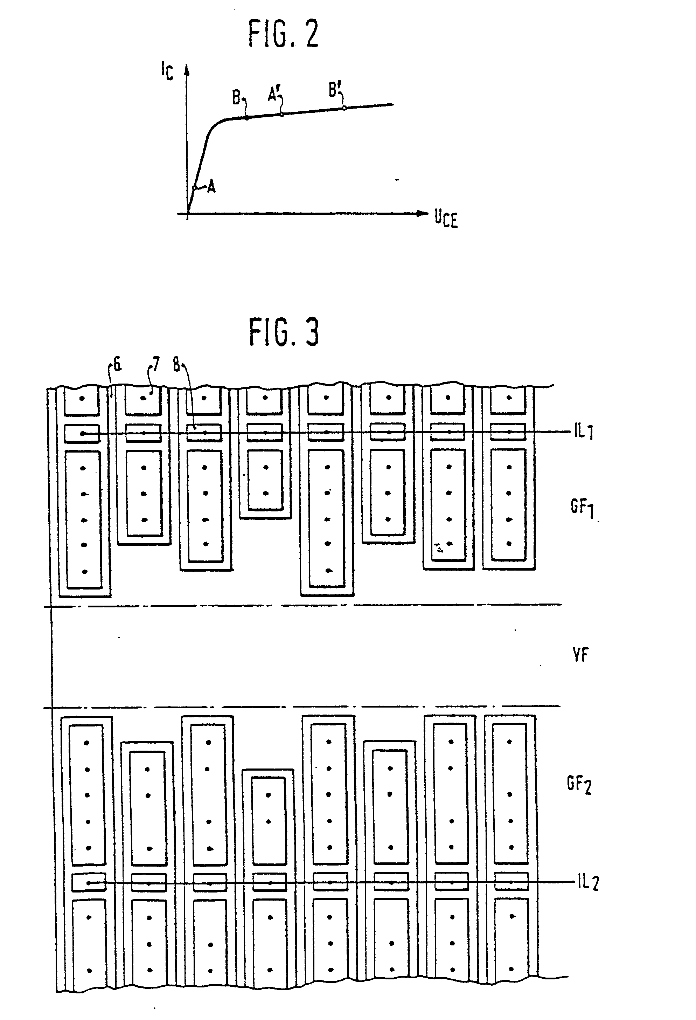

In Figur 2 sind diese Verhältnisse anhand der beiden Arbeitspunkte A (gesättigt, leitender Aufwärtstransistor) und B (nicht gesättigt, gesperrter Aufwärtstransistor) in der Ausgangskennlinie des lateralen Injektionstransistors anschaulich dargestellt. Diese Verhältnisse führen unmittelbar auf die Formulierung einer effektiven Stromverstärkung für das Gesamtgatter. Werte hierfür liegen für die Mischtechnik so risikoreich niedrig, daß sich die Anwendung dieser Technik nicht selten verbietet.

Im Bereich maximaler Schaltgeschwindigkeit der Gatter ist die Schaltverzögerungszeit annähernd konstant, weil hier die etwa stromproportionale Diffusionskapazität das Schaltverhalten beherrscht. In der Mischtechnik ist diese Diffusionskapazität aufgrund der Minioritätenspeicherung im hochohmigen Emittergebiet 4 größer als bei den auf niederohmigem Epitaxiegebiet aufgebauten Gattern der rein digitalen $I^2L$-Technik, so daß die Gatter der Mischtechnik sehr viel langsamer sind. Bei detaillierterer Betrachtung muß man die Einflüsse der gesättigten Injektorstruktur, der Basis-Bahnwiderstände und des abnehmenden Injektorstromes in Richtung vom Injektor weg mit berücksichtigen. Bei Sättigung der Injektorstruktur werden im Epitaxiegebiet 4 zusätzlich Minioritätsträger gespeichert, die in der Ausräumphase zum Teil mit ausgeräumt werden müssen, was die Ausschaltzeit des Gatters vergrößert. Weiterhin ist das Ausräumen des injektornahen Teils der Diffusionskapazität (betreffend $C_1$ und $C_2$ in Figur 1b) dadurch behindert, daß der Injektor ständig (im Ausräumen zunehmend) Strom nachliefert.

Bei höheren Injektorströmen (Bereich hoher Schaltgeschwindigkeit) kann die Injektorstruktur nicht mehr als Stromquelle betrachtet werden. Ihre niedrige Quellenspannung (Dioden-Flußspannung abzüglich Restspannung) und die Basis-Bahnwiderstände sorgen für eine zusätzlich widerstandsbegrenzte Aufladung der Diffusionskapazität, so daß die bei Stromquellenbetrieb minimal mögliche Einschaltverzögerung nicht erreicht wird, und schließlich wird in der konventionellen $I^2L$- bzw. $I^3L$-Struktur infolge der sukzessiven Abnahme des Injektorstromes in Richtung vom Injektor weg der letzte Kollektor immer zuletzt eingeschaltet. Die Zusatzverzögerungen hieraus sind zum Teil erheblich und bestimmen bei getakteter Logik die höchstzulässige Taktfrequenz. Diese Nachteile werden durch die Erfindung zum Teil beseitigt, zum Teil gemildert.

In Figur 3 sind die Layoutverhältnisse konventioneller $I^2L$- bzw. $I^3L$-Schaltungen schematisiert in der Draufsicht dargestellt. Die Kontaktfenster sind durch Punkte symbolisiert. Vom Gatteraufbau sind nur die Umrisse der schirmenden $n^+$-Tiefdiffusion 6, die Umrisse der Injektorgebiete 8 und die Umrisse der Basisgebiete der Aufwärtstransistoren 7 gezeichnet.

Die metallischen Injektorlinien $IL_1$, $IL_2$ sind aus elektrischen Gründen von Signalleitungen nur schwer zu kreuzen. Die Injektoren werden wie dargestellt in Reihe angeordnet, und zu beiden Seiten der Injektorlinien liegen Gatterfelder, von denen in Figur 3 die Gatterfelder $GF_1$ und $GF_2$ besonders gekennzeichnet sind. Zwischen den Gatterfeldern liegt je nach Notwendigkeit ein mehr oder minder breites Verdrahtungsfeld VF.

Im Gatterfeld $GF_2$ sind die Verhältnisse dargestellt, wie sie typisch auftreten: Die Gatter sind häufig länger, als sie aus elektrisch-funktionellen Gründen sein müßten, weil nicht alle zur Verfügung stehenden Kontaktplätze genutzt werden können, um so die Verdrahtung innerhalb des Gatterfeldes zu erleichtern. Dies ist vorwiegend eine Folge der an der Injektorlinie bündigen Gatterlage. Der aufgrund unterschiedlicher Gatterlängen im Gatterfeld nicht genutzte Platz ist für andere Zwecke (z.B. Verdrahtungsaufgaben des Verdrahtungsfeldes VF) nicht nutzbar. Um eine Vorstellung davon zu vermitteln, wieviel Fläche durch die Kontakt-Leerplätze einschließlich unterschiedlicher Gatterlänge insgesamt verloren geht, ist das Gatterfeld $GF_2$ im Gatterfeld $GF_1$ erneut dargestellt, wobei im Gatterfeld $GF_1$ nur die elektrisch notwendigen Gatterlängen benutzt werden. Es wird eine insgesamt nicht optimale Packungsdichte der Gatter deutlich, die gewöhnlich der vergleichsweise schwierigeren Verdrahtung der $I^2L$- bzw. $I^3L$-Technik angelastet wird. Zweifellos entstehen durch die schwer kreuzbaren Injektorlinien und das dicht verdrahtete Gatterfeld, aus dem man zusätzlich die logischen Signale herausführen muß, für die Verdrahtung Zwänge, die anderen LSI-Techniken nicht in dem Maße eigen sind. Auch eine Zweilagenverdrahtung löst das Problem nur zum geringen Teil. Man erreicht dann zwar die Form des Gatterfeldes $GF_1$, darf aber nicht erwarten, daß die gegenüberliegenden Gatterfelder so ineinanderzahnen, daß die Lücken aufgrund unterschiedlicher Gatterlänge verschwinden. Sie bleiben zum größten Teil bestehen.

Die erfindungsgemäße Lösung kennzeichnet sich hauptsächlich durch ein elektrisches Merkmal und durch ein geometrisches, die Anordnung der Elemente im lay-out beschreibendes Merkmal. In deren Gesamtfolge sind dann weitere vorteilhafte Ausbildungen elektrischer und geometrischer Art möglich.

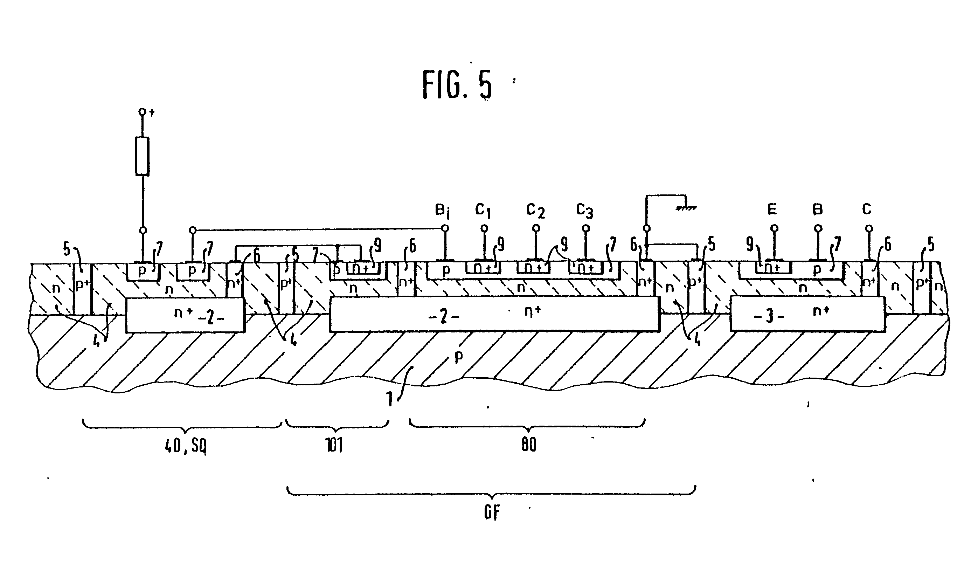

Die Aufgabe der lateralen Injektionstransistoren (8:Emitter – 4:Basis – 7:Kollektor) der konventionellen $I^2L$- bzw. $I^3L$-Strukturen nach Figur 1 ist es, die Arbeitsströme für die aufwärts verstärkenden Gattertransistoren im gesamten Gatterfeld möglichst gleichmäßig pro Gatter zur Verfügung zu stellen. Es ist also im wesentlichen die Eigenschaft einer Konstantstromquelle, die in Form der Injektoranordnung in scheinbar platzsparender Weise in das Gatter einintegriert wird. Die erheblichen elektrischen Mängel dieser Stromquelle wurden beschrieben. Eine elektrisch für diese Aufgabe weitaus besser geeignete Stromquelle erhält man, wenn anstelle des gemäß Figur 1 in das Gatter einbezogenen lateralen Injektionstransistors ein vom vertikal aufwärts verstärkenden Gattertransistor elektrisch isolierter lateraler Transistor 40 als Stromquelle verwendet wird (Figur 5). Die wesentliche Folge ist, daß das Basispotential dieses vollisolierten Transistors 40 nicht mehr wie in der konventionellen $I^2L$- bzw. $I^3L$-Struktur zwangsweise auf dem Bezugspotential des Gatters liegt, sondern im Gegensatz dazu frei wählbar ist. Darin liegt auch der wesentliche Unterschied zu der im «Fairchild Journal of Semiconductor Progress», Band 8, Nr. 2 angegebenen Struktur: Die örtliche Trennung von Injektorstruktur und vertikal aufwärts verstärkendem Gattertransistor ist dort bereits vollzogen, aber im Gegensatz zu der Lösung nach Figur 5 bleibt die elektrische Verbindung des Basispotentials des Injektionstransistors mit dem Gatter-Bezugspotential dort bestehen.

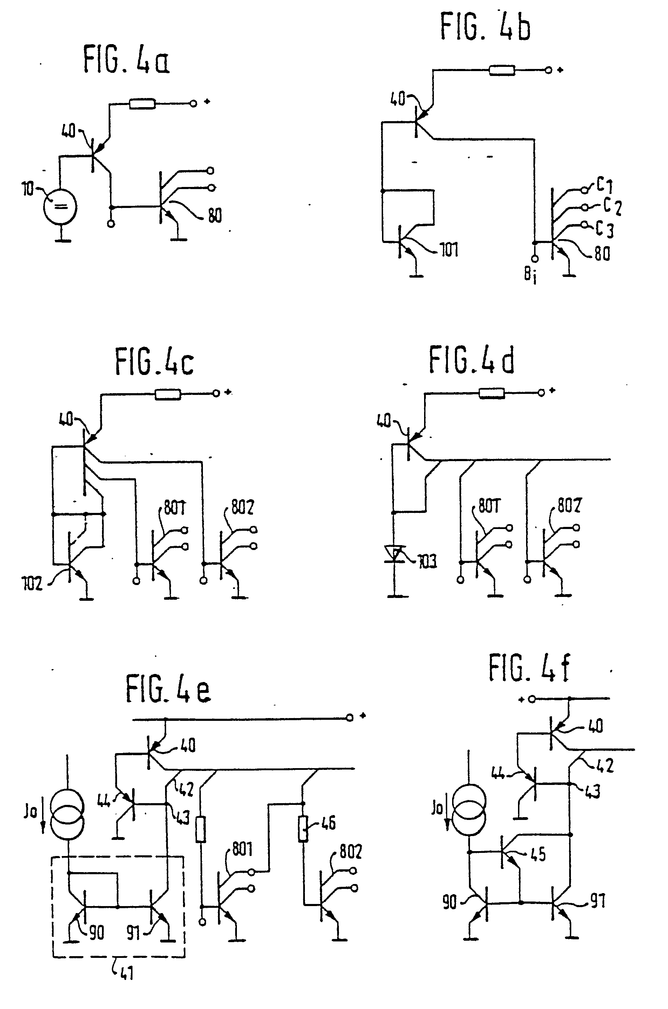

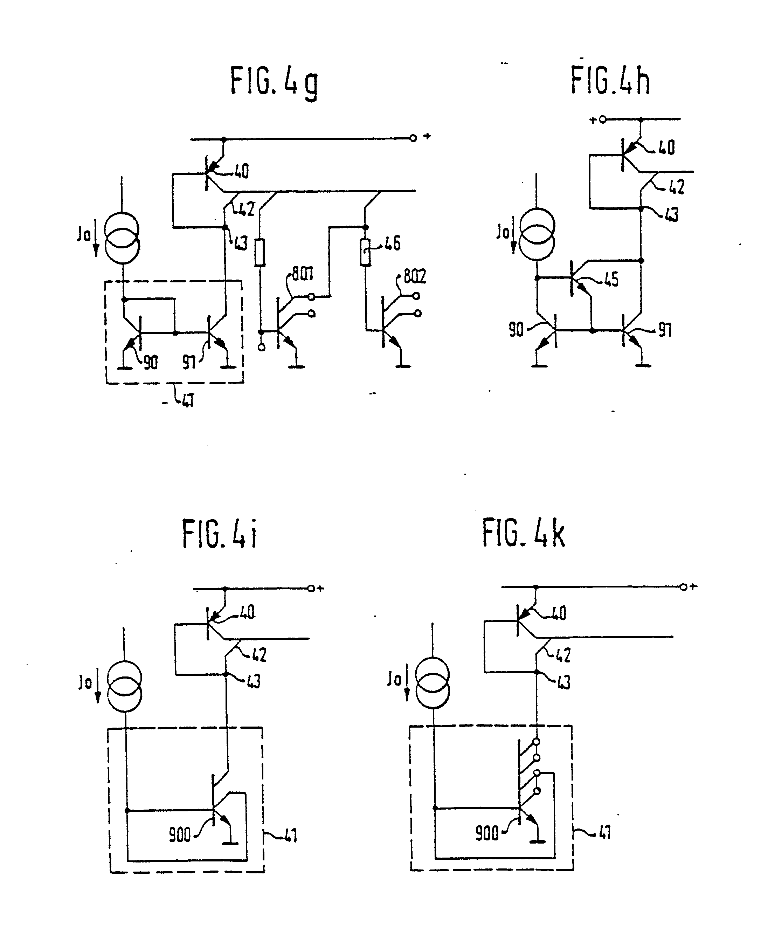

Die elektrischen Vorteile des frei verfügbaren Basispotentials am lateralen Stromquellentransistor 40 sind anhand von Figur 4 und Figur 2 ersichtlich. In Figur 4a ist das Basispotential dieses Transistors 40 zunächst nur durch eine Spannungsquelle 10 hinreichend weit über dem Bezugspotential festgelegt, so daß sich im übrigen die Betriebsweise der Stromversorgung für eine so konzipierte Gesamtschaltung nicht von der Betriebsweise der Stromversorgung konventioneller $I^2L$- bzw. $I^3L$-Schaltungen unterscheiden würde. Die elektrische Folge erkennt man anhand der Ausgangskennlinie des lateralen Stromquellentransistors in Figur 2. Die Arbeitspunkte für gesperrtes bzw. leitendes Gatter haben sich auf die Punkte A' bzw. B' eingestellt (gegenüber A bzw. B bei konventioneller $I^2L$-Technik). Die Stromdifferenz zwischen den Gatter-Schaltzuständen ist vernachlässigbar klein geworden, weil der Stromquellentransistor 40 auch bei leitendem Gatter nicht mehr im Sättigungsbetrieb arbeiten muß. Damit steht die volle Stromverstärkung des vertikalen Aufwärtstransistors 80 als Gatterstromverstärkung zur Verfügung. In konventionelle $I^2L$-Technik wäre die Gatterstromverstärkung etwa um den Quotienten aus Strom im Arbeitspunkt A zu Strom im Arbeitspunkt B vermindert.

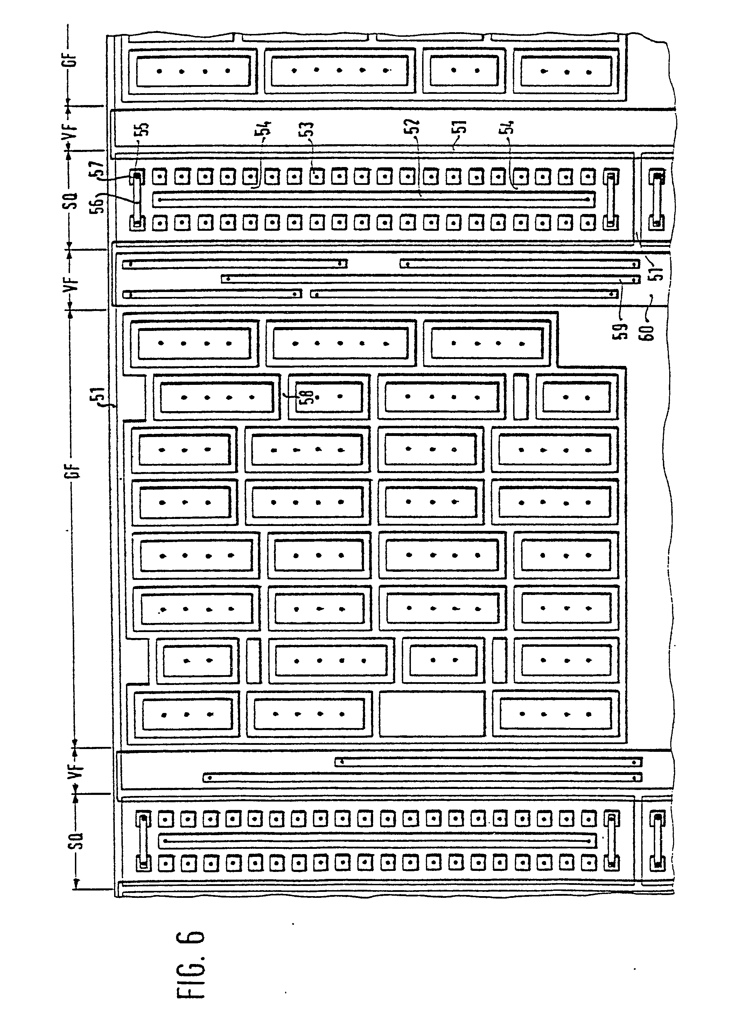

In der erfindungsgemäßen Lösung werden alle Injektorströme konventioneller $I^2L$-Technik durch Ströme aus Stromquellen 40 der beschriebenen Art ersetzt. Da man aus Platzgründen nicht für jeden Arbeitsstrom jeweils einen elektrisch vollständig isolierten Transistor 40 zur Verfügung stellen sollte, baut man diese Stromquellen vorteilhaft mit Hilfe der bekannten Lateraltransistoren mit vielfach unterteiltem Kollektor auf, wie sie auch in Figur 6 (Felder SQ) in der Draufsicht erkennbar sind, so daß jeder Teilkollektor den Arbeitsstrom für jeweils ein Gatter zur Verfügung stellt.

Die Spannungsquelle 10 in Figur 4a kann dann z.B. eine Diode 103 (Figur 4d) sein, durch die der Gesamtbasisstrom des Lateraltransistors und gegebenenfalls ein oder mehrere Ströme aus Teilkollektoren fließen. Die Diode kann in einfachster Weise aus einer Inverterstufe 101 des Gatterfeldes mit Kurzschluß zwischen Basis und Kollektor (Figur 5) bzw. mit Kurzschluß zwischen Basis und Kollektoren bestehen (siehe auch Figur 4b und 4c bzw. in vereinfachter Darstellung Figur 4d).

Im Sinne der Erfindung bietet sich allerdings die weit vorteilhaftere Lösung nach Figur 4e für die Gesamtstromversorgung des Gatterfeldes an: Ein Referenzstrom $I_o$ wird über einen Stromspiegel 41 mit dem Strom eines Teilkollektors 42 des lateralen Stromquellentransistors 40 verglichen. Das Potential des Knotenpunktes 43 stellt sich dann so ein, daß der Basisstromverstärker (Transistor 44) dem lateralen Stromquellentransistor 40 gerade so viel Basisstrom zuführt, daß der Strom aus dem Teilkollektor 42 und damit auch die Ströme aus allen anderen gleichartigen Teilkollektoren gerade gleich dem Referenzstrom $I_o$ ist. Gibt man dem Stromspiegel 41 ein von 1:1 abweichendes Übersetzungsverhältnis, dann kann auch eine Stromübersetzung zwischen dem Referenzstrom $I_o$ und dem Strom aus dem Teilkollektor 42 erzeugt werden. In einfachster Weise kann der Stromspiegel 41 wieder aus Inverterstufen des Gatterfeldes bestehen, wobei man zusätzlich das Übersetzungsverhältnis des Stromspiegels durch einen Basisstromverstärker 45 nach Figur 4f von der Stromverstärkung der Gattertransistoren abhängig machen kann.

Weitere Schaltungsvarianten sind in den Figuren 4g bis 4k dargestellt.

Die Ausführungsbeispiele nach den Figuren 4g und 4h unterscheiden sich von denjenigen nach den Figuren 4e und 4f dadurch, daß die als Basisstromverstärker wirkenden Transistoren 44 weggelassen und jeweils durch eine Kurzschlußleitung ersetzt sind, die die Basis des lateralen Stromquellentransistors 40 mit seinem Teilkollektor 42 am Knotenpunkt 43 verbindet. Bei den Ausführungsbeispielen nach den Figuren 4i und 4k wird als Stromspiegel anstelle der in den Figuren 4e und 4f enthaltenen, aus zwei bzw. drei Transistoren bestehenden Stromspiegelschaltungen ein einziger, vertikal aufwärts verstärkender Transistor 900 mit mindestens zwei Kollektoren verwendet, wobei einer (Figur 4i) oder eine erste zusammengeschaltete Gruppe (Figur 4k) dieser Kollektoren mit der Basis dieses Transistors 900 zusammengeschaltet ist und den Eingang der Stromspiegelschaltung 41 bildet und ein weiterer Kollektor (Figur 4i) oder eine zweite zusammengeschaltete Kollektorgruppe (Figur 4k) dieses Transistors 900 den Ausgang 43 der Stromspiegelschaltung 41 bildet. Der vertikal aufwärts verstärkende Transistor 900 kann dabei aus einem Gattertransistor eines Gatterfeldes GF bestehen.

Durch die Verwendung elektrisch isolierter, lateraler Stromquellentransistoren 40 im Zusammenhang mit den dargestellten Referenzschaltungen wird für die Gesamtheit der Gatterfelder einer integrierten Schaltung eine hohe Gleichmäßigkeit aller Arbeitsströme für die Gattertransistoren 80 erreicht, eine wesentlich bessere Gleichmäßigkeit, als sie für die Arbeitsströme konventioneller $I^2L$- bzw. $I^3L$-Schaltungen erreichbar ist.

Damit zusammenhängend stellt sich ein ganz wesentlicher Vorteil der Erfindung in der erheblich verbesserten Betriebs- und Störsicherheit der erfindungsgemäßen Logikschaltungen dar:

In konventioneller $I^2L$- bzw. $I^3L$-Technik wird der Arbeitsstrom eines Gatters von seinem Injektorteil geliefert. Seine Größe ist festgelegt durch die Basis-Emitter-Spannung des örtlichen Injektionstransistors, also durch die Spannung zwischen der metallischen Injektorverbindung (z.B. $IL_1$ oder $IL_2$ in Figur 3) und der das Bezugspotential führenden vergrabenen Schicht 2 (Figur 1b). Spannungsabfälle in diesen Bereichen, die idealerweise Äquipotentialbereiche sein sollten, es praktisch aber nie sind, beeinflussen exponentiell den an das Gatter gelieferten Injektorstrom. Ein Spannungsabfall von 60 mV reduziert den Injektorstrom bei Raumtemperatur auf $^1/_{10}$ des Ausgangswertes. Die konventionell zugelassenen Spannungsabfälle sind deshalb deutlich kleiner als 60 mV und ergeben auch mit den kleineren zulässigen Werten noch sehr lästige fan-out-Toleranzen für die Gatter.

Logikschaltungen nach der Erfindung sind weitgehend unempfindlich gegen solche Spannungsabfälle. Die Stromquellen liefern durch ihre Konstruktion für alle Gatter unter allen praktischen Betriebsbedingungen etwa gleiche Arbeitsströme. Die Sättigungspotentiale der Stromquellen liegen von vornherein so hoch, daß die Öffnungsspannungen für die Gattertransistoren (vertikale Aufwärtstransistoren) immer erreicht werden. Auch zusätzliche Spannungsabfälle zwischen Stromquelle (Teilkollektor) und Basis des Gattertransistors – etwa durch verbindende $n^+$-Brücken (46 in Figur 4e) oder den Basisbahnwiderstand des Gattertransistors selbst verursacht – können zugelassen werden, weil vom Kollektor des Stromquellentransistors 40 her genügend Spannungsraum zur Verfügung steht (nicht so bei konventionellem Injektor). Nimmt man andererseits für den Sperrfall an, daß das Bezugspotential eines zu sperrenden Gatters aufgrund von Spannungsabfällen auf der das Bezugspotential führenden vergrabenen Schicht 2 (Figur 1b) etwa 200 mV niedriger liegt als das Bezugspotential des weit entfernt liegenden sperrenden Gatters, dann ist die Sperrung des ersten Gatters immer noch gewährleistet, weil ihm die restliche Ansteuerspannung (200 mV + Restspannung des sperrenden Gatters) zum Aufrechterhalten des Flußzustandes nicht ausreicht. Aufgrund dieses Vorteils ist es möglich, auch größere Temperaturgradienten auf den Kristallen (Mischtechnik mit analogen Leistungsstufen) und rauhere Umgebungsbedingungen (Kraftfahrzeug) zuzulassen.

Der Arbeitsstrom wird dem Gatter immer über seinen Basiskontakt zugeführt und wird durch ein sperrendes Gatter auch immer am Basiskontakt abgefangen, so daß das gesperrte Gatter vollständig stromlos ist. Der ständig stromliefernde Injektor konventioneller Art ist aus dem Gatter entfernt, so daß die Sperrbehinderung der injektornahen Gatterkollektoren entfällt.

Das minoritätengesättigte Injektorvolumen des Gatters ist nicht mehr vorhanden, so daß die dadurch verursachte Sperrverzögerung entfällt.

Die widerstandsbegrenzte (Basisbahnwiderstand) Aufladung der Diffusionskapazitäten entfällt, weil von der Stromquelle her genügend Flußspannung zur Verfügung steht. Die Zuführung des Arbeitsstromes geschieht konventionell aus der elektrisch ungünstigsten Position an der Schmalseite des langgestreckten Gatterstreifens (Figur 3). Nach der Erfindung ergibt sich für die Zuführung über den Basiskontakt $B_i$ stets eine günstigere Position (Figur 5).

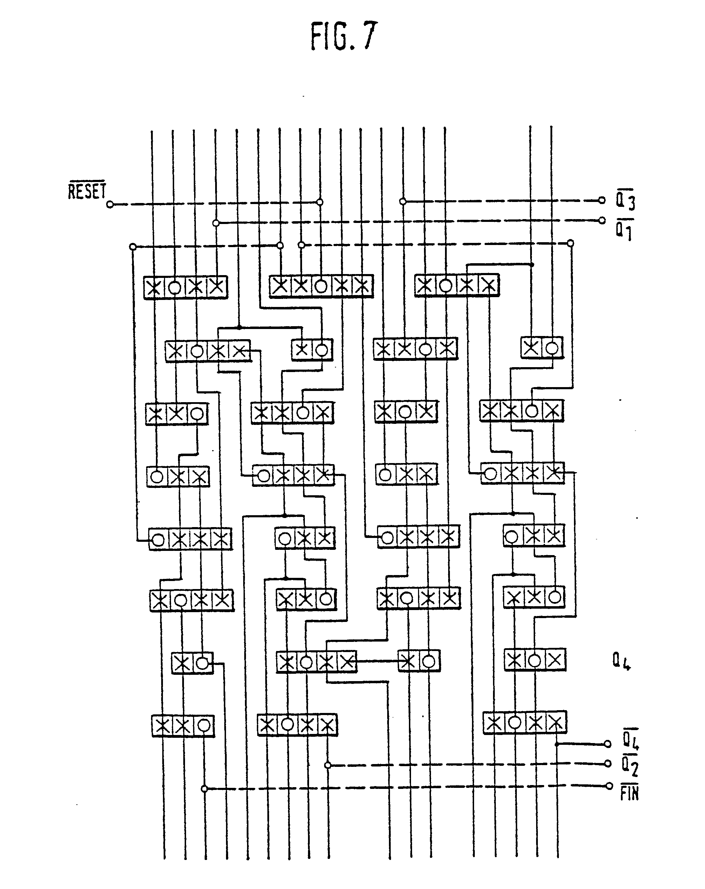

In Figur 6 ist ein vereinfachtes lay-out eines vierstufigen asynchronen Frequenzteilers dargestellt. Die Kontaktfenster sind durch Punkte gestellt. Die Begrenzungslinien der Gatterkollektoren (Emitterdiffusion) im Gatterstreifen und die Leiterbahnen wurden zwecks Übersichtlichkeit nicht eingezeichnet. Figur 7 zeigt das formale lay-out der Frequenzteilerstufe. Dargestellt sind hier die Gatterstreifen mit ihren Kollektoranschlüssen (x) und ihren Basisanschlüssen (o) sowie den leitenden Verbindungen aus Metall oder polykristallinem Halbleitermaterial (durchgezogene Linien) und die Brücken aus niederohmigem, diffundiertem Halbleitermaterial (gestrichelte Linien). Die aus dem Gatterfeld oben und unten herausgeführten Leiterbahnen führen je zu einem Teilkollektor der lateralen Stromquellentransistoren 40.

In der Grobstruktur unterscheidet man in Figur 6 die Bereiche für

laterale Stromquellentransistoren     SQ
Gatterfeld     GF
Verdrahtungsfeld     VF.

Die prinzipielle Grobstruktur der Anordnung wird zweckmäßigerweise immer so aussehen, wobei in den Randbereichen der Gesamtschaltung das letzte Verdrahtungsfeld und der dahinter liegende Stromquellentransistor 40 (vom Gatterfeld aus gesehen) entfallen können. Bei sehr einfachen Schaltungen oder bei Verwendung einer Zweilagenverdrahtung kann das Verdrahtungsfeld VF zwischen Gatterfeld GF und Stromquellen SQ entfallen. Aus der Zweckmäßigkeit der Anordnung entstehen folgende Merkmale:

1. Die längeren Seiten der Stromquellentransistoren 40 im Feld SQ und die längeren Seiten der Gattertransistoren 80 im Feld GF verlaufen parallel.

2. Wenn ein Verdrahtungsfeld VF mit den charakterisierenden Brücken 59 aus gut leitendem, diffundiertem Halbleitermaterial zwischen dem Gatterfeld GF und dem Stromquellentransistor 40 (Feld SQ) vorhanden ist (das wird bei Einlagenverdrahtung meistens der Fall sein), dann verlaufen die längeren Seiten der Brücken 59 vorwiegend parallel zur längeren Seite des angrenzenden Stromquellentransistors 40 (Feld SQ).

3. Die Hauptrichtung der aus Metall oder polykristallinem Halbleitermaterial bestehenden leitenden Verbindungen im Gatterfeld GF verläuft (Fig. 7) senkrecht zur längeren Seite der Gattertransistoren (Hauptrichtung: Die Summe der in einer Richtung verlaufenden Leiterbahnabschnitte wird in der Hauptrichtung maximal).

4. Diejenigen Gatterfelder GF, die zwischen zwei Stromquellentransistoren (Felder SQ in Fig. 6) liegen und von beiden Stromquellentransistoren mit Arbeitsströmen versorgt werden, bestehen überwiegend aus sechs bis zehn Gatterzeilen.

Die Stromquellentransistoren (Feld SQ) sind elektrisch isolierte Lateraltransistoren und sind deshalb stets vollständig von Gebieten der Isolationsdiffusion 51 umschlossen. Der langgestreckte Emitter 52 des Transistors, bestehend aus Material der Basisdiffusion, liegt im allgemeinen in der Mittellinie des Transistors. Zu beiden Seiten des Emitters 52 liegt eine Vielzahl von ebenfalls aus Material der Basisdiffusion bestehenden Kollektoren 53, denen die einzelnen Arbeitsströme für das Gatterfeld GF, Treiberstufen und Referenzschaltungen entnommen werden. Für jeden Stromquellentransistor SQ muß wenigstens ein Basisanschluß 55 zur Verfügung stehen. Die elektrische Transistorbasis 54 wird von dem Epitaxiematerial zwischen dem Emitter 52 und den einzelnen Kollektoren 53 gebildet. Ihr durchgehend guter elektrischer Kontakt zum Basisanschluß 55 entscheidet über das erreichbare Gleichmaß aller Kollektorströme. Spannungsabfälle zwischen den elektrischen Transistorbasen 54 und dem Basiskontakt 55 stören dieses Gleichmaß. Im Stromquellentransistor 40; SQ befindet sich deshalb zweckmäßigerweise unter dem gesamten Gebiet, das den Emitter, die Kollektoren und die Basisanschlüsse umfaßt, eine niederohmige vergrabene Schicht 2 (Figur 5), die die Bereiche der elektrischen Transistorbasen 54 gut leitend mit den Bereichen der Basisanschlüsse verbindet. Die Basisanschlüsse selbst werden zweckmäßigerweise mit Hilfe der Kollektor-Tiefdiffusion 56 (Zone 6 im Bereich 40 der Figur 5) mit der vergrabenen Schicht elektrisch verbunden. Zur Verbesserung der Kontaktgabe kann dem Basiskontakt 55 ein Gebiet 57 aus Material der Emitterdiffusion 9 unterlegt werden. Mit diesen Maßnahmen läßt sich der Spannungsabfall längs der Basisstrombahnen gering halten und damit ein solches Gleichmaß der Kollektorströme erreichen, daß ein Gatterfeld GF ohne Risiko aus verschiedenen Stromquellentransistoren SQ versorgt werden kann.

Statistische Untersuchungen von $I^2L$-Schaltungen zeigen, daß die Gattertransistoren mit zwei Kollektoren und mit drei Kollektoren am häufigsten vorkommen, also Gattertransistoren, die einschließlich Basiskontakt über drei und vier Anschlußplätze (Kontaktfenster) verfügen. Man baut das Gatterfeld GF deshalb zweckmäßigerweise in erster Grobstruktur aus Spalten senkrecht zur Längsrichtung der Stromquellentransistoren SQ auf, deren Breite abwechselnd für drei und vier Kontaktplätze bemessen ist, wobei der Platz für die zwischen den Gattern liegende (abschirmende) Kollektor-Tiefdiffusion 58 (Zone 6 im $I^2L$-Teil der Figuren 1a und 1b) zu berücksichtigen ist. Schaltung und lay-out-Erfordernisse zwingen dann dazu, dieses starre Schema zu durchbrechen: Es müssen Gatter mit abweichender Zahl von Kollektorplätzen eingefügt werden, und es paßt die starre Spaltenbildung fast nie in die Überlegungen eines sinnvollen lay-out. Daraus resultiert letztlich die in Figur 6 am praktischen Beispiel gezeigte Struktur des Gatterfeldes GF mit den ineinanderzahnenden Gattertransistoren. Man erkennt aber in der Mitte des Gatterfeldes GF auch noch die ursprüngliche Spaltenstruktur. Obwohl sich Leerplätze zwischen den Gattern nicht vermeiden lassen, ist die Packungsdichte solcher Gatterfelder deutlich höher als in konventionellen $I^2L$- bzw. $I^3L$-Gatterfeldern gemäß Figur 3. Das in Figur 6 dargestellte Gatterfeld GF belegt die Fläche für 112 Kontaktplätze, die gleiche Schaltung würde konventionell (ohne Injektorplätze) die Fläche für ca. 130 Kontaktplätze belegen. Der Grund besteht darin, daß die Gatter nicht länger als elektrisch notwendig sind und daß Leerplätze aus unterschiedlichen Gatterlängen durch Ineinanderschachteln zum größeren Teil genutzt werden können.

Die Verdrahtung im Gatterfeld ist für gatterkreuzende Leiterbahnen nur über einen Kontaktplatz des Gatters möglich (konventionell genauso), für gatterpassierende Leiterbahnen steht die Lücke zwischen den Gattern zur Verfügung. Hier können sowohl senkrecht als auch waagerecht zwei Leiterbahnen parallel geführt werden. Das ist konventionell im Prinzip auch möglich, nur kann man dort wegen der andersartigen Gatteranordnung so gut wie keinen Gebrauch von zwei parallelen Leiterbahnen zwischen den Gattern machen. In der erfindungsgemäßen Anordnung der Gatter kann man diese Verdrahtungsmöglichkeiten nutzen. Das gibt dem lay-out erfahrungsgemäß mehr als nur die Freiheit, die zum Anbringen der zusätzlichen Leiterbahnen für die Arbeitsströme aus Stromquellentransistoren nötig ist. Der Verdrahtungsraum reicht aus, um bis zu zehn Gatterzeilen zwischen zwei Stromquellentransistoren anordnen zu können. Das bedeutet, daß ein D-Flip-Flop mit sechs bis neun Gattern (als wichtigste Großzelle) in einer Spalte zwischen zwei Stromquellentransistoren angeordnet werden kann.

Die Verdrahtungsfelder VF liegen zwischen dem Gatterfeld GF und dem Stromquellentransistor bzw. den Stromquellentransistoren. Über die Verdrahtungsfelder VF hinweg müssen sämtliche Arbeitsströme in das Gatterfeld GF geführt werden. Das bedeutet aber, daß alle logischen Signale in den Verdrahtungsfeldern VF zur Verfügung stehen, denn die Potentiale der Arbeitsstrom-Leiterbahnen sind die logischen Signale. Damit ist die Aufgabe der Verdrahtungsfelder gegeben: Auskoppeln logischer Signale und Kreuzen von Signalleitungen, wenn sich dies in der Verdrahtung des Gatterfeldes nicht erreichen läßt.

Die Leiterbahnen des Verdrahtungsfeldes VF sind bei einlagiger Verdrahtung die Brücken 59 aus Material der Emitterdiffusion. Sie liegen in einem entgegengesetzt dotierten Gebiet 60 aus Material der Basisdiffusion, das zur elektrischen Kontaktierung mit dem Gebiet 51 überlappt, welches den Stromquellentransistor SQ umrandet.

Der Gesamtflächenaufwand für die erfindungsgemäße Lösung ist zunächst belastet durch die zusätzlichen, vollisolierten Stromquellentransistoren SQ. Der Wegfall der Injektoren in den Gatterfeldern kompensiert diesen Zusatzaufwand nur teilweise. Die zweckvollere Anordnung des Gatterfeldes und damit untrennbar verbunden die Systematisierung des Verdrahtungsproblems und die hierfür größere Freiheit im Gatterfeld ergeben insgesamt einen Flächenvorteil für Schaltungen, die mehr als etwa 80 Gatter enthalten.

Die Erfindung ist nicht auf die anhand der Zeichnung beschriebenen Ausführungsbeispiele beschränkt. Insbesondere sind auch die inversen Strukturen und Schaltungen denkbar, bei denen die p-leitenden Zonen durch n-leitende Zonen ersetzt sind und umgekehrt.

**Patentansprüche**

1. Bipolar integrierte Inverstransistorlogik mit mindestens einem vertikal aufwärts verstärkenden Gattertransistor (80; 801, 802,...) und mindestens einem von diesem räumlich getrennten lateralen Stromquellentransistor (40), der einen zum Gattertransistor (80; 801, 802,...) entgegengesetzten Leitungstyp und mindestens einen Kollektor hat, der an die Basis des Gattertransistors (80; 801, 802,...) angeschlossen ist, wobei der laterale Stromquellentransistor (40) innerhalb des Halbleiterkristalles elektrisch isoliert gegen den Gattertransistor (80; 801, 802,...) untergebracht ist und wobei ferner das Basispotential des lateralen Stromquellentransistors (40) gegenüber dem als Gatter-Bezugspotential dienenden Emitterpotential des Gattertransistors (80; 801, 802,...) derart veränderbar ist, daß die volle Stromverstärkung des Gattertransistors (80; 801, 802,...) als Gatterstromverstärkung zur Verfügung steht, dadurch gekennzeichnet, daß der laterale Stromquellentransistor (40) einen weiteren Kollektor (42) hat, der an den Ausgang (43) einer Stromspiegelschaltung (41) angeschlossen ist, deren Eingang ein Referenzstrom ($I_o$) zugeführt ist, wobei der weitere Kollektor (42) des lateralen Stromquellentransistors (40) außerdem mit der Basis dieses Transistors (40) verbunden ist (Figur 4e, 4f, 4g, 4h, 4i, 4k).

2. Inverstransistorlogik nach Anspruch 1, dadurch gekennzeichnet, daß der weitere Kollektor (42) des lateralen Stromquellentransistors (40) mit dessen Basis kurzgeschlossen ist (Figur 4g, 4h, 4i, 4k).

3. Inverstransistorlogik nach Anspruch 1, dadurch gekennzeichnet, daß zur Verbindung des weiteren Kollektors (42) des lateralen Stromquellentransistors (40) mit dessen Basis ein als Basisstromverstärker wirkender, den gleichen Leitungstyp wie der laterale Stromquellentransistor (40) aufweisender Transistor (44) vorgesehen ist, dessen Emitter an die Basis des lateralen Stromquellentransistors (40) und dessen Basis an den weiteren Kollektor (42) des lateralen Stromquellentransistors (40) angeschlossen ist und dessen Kollektor auf dem als Gatter-Bezugspotential dienenden Emitterpotential des Gattertransistors (801, 802) liegt (Figur 4e, 4f).

4. Inverstransistorlogik nach einem der Ansprüche 1 bis 3, dadurch gekennzeichnet, daß die Stromspiegelschaltung (41) einen ersten Transistor (90) und einen zweiten Transistor (91), beide vom gleichen Leitungstyp wie der Gattertransistor (801, 802), enthält, wobei der Kollektor des ersten Transistor (90) den Eingang der Stromspiegelschaltung (41) und der Kollektor des zweiten Transistor (91) den Ausgang (43) der Stromspiegelschaltung (41) bildet, die Emitter der beiden genannten Transistoren (90, 91) auf dem als Gatter-Bezugspotential dienenden Emitterpotential des Gattertransistors (801, 802) liegen und die Basen der beiden genannten Transistoren (90, 91) aneinander angeschlossen und mit dem Kollektor des ersten Transistors (90) verbunden sind (Figur 4e, 4f).

5. Inverstransistorlogik nach Anspruch 4, dadurch gekennzeichnet, daß die Basen der beiden genannten Transistoren (90, 91) der Stromspiegelschaltung (41) mit dem Kollektor des ersten Transistors (90) kurzgeschlossen sind (Figur 4e).

6. Inverstransistorlogik nach Anspruch 4, dadurch gekennzeichnet, daß zur Verbindung der Basen der beiden genannten Transistoren (90, 91) der Stromspiegelschaltung (41) mit dem Kollektor des ersten Transistors (90) ein als Basisstromverstärker wirkender, den gleichen Leitungstyp wie der Gattertransistor (801, 802) aufweisender dritter Transistor (45) vorgesehen ist, der mit seinem Emitter an die Basen der beiden genannten Transistoren (90, 91) angeschlossen ist, mit seiner Basis an den Kollektor des ersten Transistors (90) und mit seinem Kollektor an den Kollektor des zweiten Transistors (91) angeschlossen ist (Figur 4f).

7. Inverstransistorlogik nach einem der Ansprüche 1 bis 3, dadurch gekennzeichnet, daß die Stromspiegelschaltung (41) aus einem einzigen Transistor (900) besteht, der den gleichen Leitungstyp wie der Gattertransistor (801, 802) hat und mindestens zwei Kollektoren aufweist, wobei einer oder eine erste zusammengeschaltete Gruppe dieser Kollektoren mit der Basis dieses Transistors (900) zusammengeschaltet ist und den Eingang der Stromspiegelschaltung (41) bildet und ein weiterer Kollektor oder eine zweite zusammengeschaltete Kollektorgruppe dieses Transistors (900) den Ausgang (43) der Stromspiegelschaltung (41) bildet und wobei ferner der Emitter dieses einzigen die Stromspiegelschaltung (41) bildenden Transistors (900) auf dem als Gatter-Bezugspotential dienenden Emitterpotential des Gattertransistors (801, 802) liegt (Figur 4i, 4k).

8. Inverstransistorlogik nach einem der Ansprüche 4 bis 7, dadurch gekennzeichnet, daß der erste Transistor (90) und der zweite Transistor (91) bzw. der einzige Transistor (900) der Stromspiegelschaltung (41) als vertikal aufwärts verstärkender Transistor ausgebildet ist.

9. Inverstransistorlogik nach einem der Ansprüche 1 bis 8 mit einer Vielzahl vertikal aufwärts verstärkender Gattertransistoren (80; 801, 802,...), die jeweils mit einem aus einem lateralen Stromquellentransistor (40) stammenden Arbeitsstrom versorgt werden, dadurch gekennzeichnet, daß zur Bereitstellung dieser Arbeitsströme Vielkollektor-Stromquellentransistoren (40) verwendet werden, wobei jeder Kollektor oder die Mehrzahl der Kollektoren dieser Vielkollektor-Stromquellentransistoren (40) je einzeln zur Bereitstellung des Arbeitsstromes für einen einzigen vertikal aufwärts verstärkenden Gattertransistor (80; 801, 802,...) dient.

10. Inverstransistorlogik nach Anspruch 9, dadurch gekennzeichnet, daß für die Gattertransistoren (80; 801, 802,...) und für die Vielkollektor-Stromquellentransistoren (40) jeweils getrennte Felder (GF, SQ) vorgesehen sind, wobei die Verdrahtung der Gesamtschaltung durch auf dem Halbleiterkristall verlaufende, gegen diesen isolierte Leiterbahnen aus Metall und/oder aus polykristallinem Halbleitermaterial und/oder durch im Halbleiterkristall verlaufende Brücken (59) aus niederohmigem, diffundiertem Halbleitermaterial gebildet wird.

11. Inverstransistorlogik nach Anspruch 10, dadurch gekennzeichnet, daß für die im Halbleiterkristall verlaufenden Verdrahtungsbrücken (59) aus niederohmigem, diffundiertem Halbleitermaterial besondere, als Verdrahtungsfelder (VF) dienende Felder vorgesehen sind.

12. Inverstransistorlogik nach Anspruch 10, dadurch gekennzeichnet, daß in einem Vielkollektor-Stromquellentransistorfeld (SQ) ein einziger Vielkollektor-Stromquellentransistor (40) untergebracht ist, daß das Vielkollektor-Stromquellentransistorfeld (SQ) einen langgestreckten, schmalen Streifen bildet, daß der Emitter (52) des Vielkollektor-Stromquellentransistors (40) sich in Längsrichtung dieses Streifens erstreckt und daß die Kollektoren (53) entlang diesem Emitterstreifen (52) in gleichen Abständen zueinander angeordnet sind.

13. Inverstransistorlogik nach Anspruch 12, dadurch gekennzeichnet, daß die Kollektoren (53) an einer der beiden Längsseiten des Emitterstreifens (52) angeordnet sind.

14. Inverstransistorlogik nach Anspruch 12, dadurch gekennzeichnet, daß die Kollektoren (53) an beiden Längsseiten des Emitterstreifens (52) angeordnet sind.

15. Inverstransistorlogik nach einem der Ansprüche 10 bis 14, dadurch gekennzeichnet, daß die vertikal aufwärts verstärkenden Gattertransistoren (80; 801, 802,...) im Gatterfeld (GF) in der Draufsicht rechteckförmige Gebilde sind, in denen die äußeren Anschlüsse (B$_i$, C$_1$, C$_2$, C$_3$,...) parallel zur längeren Seite des Rechtecks angeordnet sind.

16. Inverstransistorlogik nach den Ansprüchen 9, 10, 12, 15 und nach einem der Ansprüche 13 und 14, dadurch gekennzeichnet, daß die Längsseiten der Vielkollektor-Stromquellentransistorfelder (SQ) und die längeren Seiten der Gattertransistoren (80; 801, 802,...) in den Gatterfeldern (GF) parallel verlaufen.

17. Inverstransistorlogik nach den Ansprüchen 10 und 11, dadurch gekennzeichnet, daß zwischen einem Gatterfeld (GF) und einem Vielkollektor-Stromquellentransistorfeld (SQ) ein Verdrahtungsfeld (VF) angeordnet ist.

18. Inverstransistorlogik nach den Ansprüchen 10 bis 12 und 17, dadurch gekennzeichnet, daß die im Verdrahtungsfeld (VF) verlaufenden Brücken (59) aus niederohmigem, diffundiertem Halbleitermaterial überwiegend parallel zu dem langgestreckten schmalen Streifen des Vielkollektor-Stromquellentransistorfeldes (SQ) verlaufen.

19. Inverstransistorlogik nach den Ansprüchen 10 und 15, dadurch gekennzeichnet, daß die auf dem Halbleiterkristall verlaufenden, gegen diesen isolierten Leiterbahnen aus Metall und/oder polykristallinem Halbleitermaterial im Gatterfeld (GF) überwiegend senkrecht zur längeren Seite der Gattertransistoren (80; 801, 802,...) verlaufen.

20. Inverstransistorlogik nach Anspruch 16, dadurch gekennzeichnet, daß zwischen zwei Vielkollektor-Stromquellentransistorfeldern (SQ) ein einziges Gatterfeld (GF) angeordnet ist, das von diesen beiden Vielkollektor-Stromquellentransistorfeldern (SQ) mit Arbeitsströmen versorgt wird.

21. Inverstransistorlogik nach Anspruch 20, dadurch gekennzeichnet, daß das Gatterfeld (GF) sechs bis zehn Gatterzeilen enthält.

22. Inverstransistorlogik nach den Ansprüchen 7 und 8 und nach mindestens einem der Ansprüche 10 bis 21, dadurch gekennzeichnet, daß für den die Stromspiegelschaltung (41) bildenden einzigen vertikal aufwärts verstärkenden Transistor (900) ein Gattertransistor (80) eines Gatterfeldes (GF) verwendet wird.

**Claims**

1. Integrated logic using inverse bipolar transistors, comprising at least one gate transistor (80; 801, 802,...) which amplifies vertically upwards and at least one lateral current source transistor (40) which is spatially separated from the former and which has a type of conduction which is opposite to the gate transistor (80; 801, 802,...) and has at least one collector which is connected to the base of the gate transistor (80; 801, 802,...), the lateral current source transistor (40) being accommodated electrically insulated with respect to the gate transistor (80; 801, 802,...) within the semiconductor crystal and in which arrangement, furthermore, the base potential of the lateral current source transistor (40) with respect to the emitter potential of the gate transistor (80; 801, 802,...) used as gate reference potential can be changed in such a manner that the full current gain of the gate transistor (80; 801, 802,...) is available as gate current gain, characterised in that the lateral current source transistor (40) has a further collector (42) which is connected to the output (43) of a current balancing circuit (41) the input of which is supplied with a reference current (I$_o$), the further collector (42) of the lateral current source transistor (40) also being connected to the base of this transistor (40) (Figure 4e, 4f, 4g, 4h, 4i, 4k).

2. Inverse transistor logic according to Claim 1, characterised in that the further collector (42) of the lateral current source transistor (40) is short circuited to its base (Figure 4g, 4h, 4i, 4k).

3. Inverse transistor logic according to Claim 1, characterised in that, for connecting the further collector (42) of the lateral current source transistor (40) to its base, a transistor (44) is provided which acts as base current amplifier and exhibits the same type of conduction as the lateral current source transistor (40) and the emitter of which is connected to the base of the lateral current source transistor (40) and the base of which is connected to the further collector (42) of the lateral current source transistor (40) and the collector of which is connected to the emitter potential of the gate transistor (801, 802) which is used as gate reference potential (Figure 4e, 4f).

4. Inverse transistor logic according to one of Claims 1 to 3, characterised in that the current balancing circuit (41) contains a first transistor (90) and a second transistor (91), both of the same type of conduction as the gate transistor (801, 802), in which arrangement the collector of the first transistor (90) forms the input of the current balancing circuit (41) and the collector of the second transistor (91) forms the output (43) of the current balancing circuit (41), the emitters of the two said transistors (90, 91) are connected to the emitter potential of the gate transistor (801, 802) which is used as gate reference potential and the bases of the two said transistors (90, 91) are connected to one another and are connected to the collector of the first transistor (90) (Figure 4e, 4f).

5. Inverse transistor logic according to Claim 4, characterised in that the bases of the two said transistors (90, 91) of the current balancing circuit (41) are short-circuited to the collector of the first transistor (90) (Figure 4e).

6. Inverse transistor logic according to Claim 4, characterised in that, for connecting the bases of the two said transistors (90, 91) of the current balancing circuit (41) to the collector of the first transistor (90), a third transistor (45) is provided which acts as base current amplifier and exhibits the same type of conduction as the gate transistor (81, 82) and which is connected with its emitter to the bases of the two said transistors (90, 91), if connected with its base to the collector of the first transistor (90) and with its collector to the collector of the second transistor (91) (Figure 4f).

7. Inverse transistor logic according to one of Claims 1 to 3, characterised in that the current balancing circuit (41) consists of a single transistor (900) which has the same type of conduction as the gate transistor (801, 802) and exhibits at least two collectors, in which arrangement one or a first group, which is connected together, of these collectors is connected together with the base of this transistor (900) and forms the input of the current balancing circuit (41) and a further collector or a second collector group, which is connected together, of this transistor (900) forms the output (43) of the current balancing circuit (41), and in which arrangement furthermore the emitter of this single transistor (900) forming the current balancing circuit (41) is connected to the emitter potential of the gate transistor (801, 802) which is used as gate reference potential (Figure 4i, 4k).

8. Inverse transistor logic according to one of Claims 4 to 7, characterised in that the first transistor (90) and the second transistor (91) or the single transistor (900) of the current balancing circuit (41) is constructed as transistor which amplifies vertically upwards.

9. Inverse transistor logic according to one of Claims 1 to 8, comprising a large number of gate transistors (80; 801, 802,...) which amplify vertically upwards and which in each case are supplied with an operating current originating from a lateral current source transistor (40), characterised in that multi-collector current source transistors (40) are used for providing these operating currents, in which arrangement each collector or the plurality of collectors of these multi-collector current source transistors (40) are each individually used for providing the operating current for a single gate transistor (80; 801, 802,...) which amplifies vertically upwards.

10. Inverse transistor logic according to Claim 9, characterised in that in each case separate fields (GF, SQ) are provided for the gate transistors (80; 801, 802,...) and for the multi-collector current source transistors (40), in which arrangement the wiring of the whole circuit is formed by conductor tracks of metal and/or of polycrystalline semiconductor material and/or by links (59), which extend in the semiconductor crystal, of low-resistance diffused semiconductor material, which extend on the semiconductor crystal and are insulated with respect to the latter.

11. Inverse transistor logic according to Claim 10, characterised in that special fields used as wiring fields (VF) are provided for the wiring links (59) of low-resistance diffused semiconductor material extending in the semiconductor crystal.

12. Inverse transistor logic according to Claim 10, characterised in that a single multi-collector current source transistor (40) is accommodated in a multi-collector current source transistor field (SQ), that the multi-collector current source transistor field (SQ) forms an elongated narrow strip, that the emitter (52) of the multi-collector current source transistor (40) extends in the longitudinal direction of this strip, and that the collectors (53) are arranged at equal distances from one another along this emitter strip (52).

13. Inverse transistor logic according to Claim 12, characterised in that the collectors (53) are arranged at one of the two longitudinal sides of the emitter strip (52).

14. Inverse transistor logic according to Claim 12, characterised in that the collectors (53) are arranged at both longitudinal sides of the emitter strip (52).

15. Inverse transistor logic according to one of Claims 10 to 14, characterised in that the gate transistors (80; 801, 802,...), which amplify vertically upwards, in the gate field (GF) are rectangular structures in a top view, in which the outer connections ($B_i$, $C_1$, $C_2$, $C_3$,...) are arranged parallel to the longer side of the rectangle.

16. Inverse transistor logic according to Claim 9, 10, 12, 15 and according to one of Claims 13 and 14, characterised in that the longitudinal sides of the multi-collector current source transistor fields (SQ) and the longer sides of the gate transistors (80; 801, 802,...) extend in parallel in the gate fields (GF).

17. Inverse transistor logic according to Claims 10 and 11, characterised in that a wiring field (VF) is arranged between a gate field (GF) and a multi-collector current source transistor field (SQ).

18. Inverse transistor logic according to Claims 10 to 12 and 17, characterised in that the links (59) of low-resistance diffused semiconductor material extending in the wiring field (VF) extend to a large extent parallel to the elongated narrow strip of the multi-collector current source transistor field (SQ).

19. Inverse transistor logic according to Claims 10 and 15, characterised in that the conductor tracks of metal and/or polycrystalline semiconductor material, extending on the semiconductor crystal and insulated with respect to the latter, in the gate field (GF) extend to a large extent perpendicularly with respect to the longer side of the gate transistors (80; 801, 802,...).

20. Inverse transistor logic according to Claim 16, characterised in that between two multi-collector current source transistor fields (SQ) a single gate field (GF) is arranged which is supplied with operating currents from both these two multi-collector current source transistor fields (SQ).

21. Inverse transistor logic according to Claim 20, characterised in that the gate field (GF) contains six to ten gate rows.

22. Inverse transistor logic according to Claims 7 and 8 and according to at least one of Claims 10 to 21, characterised in that a gate transistor (80) of a gate field (GF) is used for the single transistor (900), which amplifies vertically upwards and forms the current balancing circuit (41).

## Revendications

1. Logique intégrée à transistors bipolaires inverses comportant au moins un transistor de portes vertical à amplification ascendante (80; 801, 802,...) et au moins un transistor latéral (40) source de courant séparé du précédent dans l'espace, et qui est d'une conductibilité de type opposé de celle du transistor de portes (80; 801, 802,...) et possède au moins un collecteur relié à la base du transistor de portes (80; 801, 802,...), le transistor latéral (40) formant source de courant étant logé de manière électriquement isolée dans le cristal semi-conducteur par rapport aux transistors de portes (80; 801, 802,...) et en outre le potentiel de base du transistor latéral (40) formant source de courant peut être modifié par rapport au potentiel d'émetteur du transistor de portes (80; 801, 802,...) servant de potentiel de référence de portes de façon que l'ensemble de l'amplification du courant du transistor de portes (80; 801, 802,...) soit disponible pour l'amplification du courant de portes, logique caractérisée en ce que le transistor latéral (40) formant source de courant comporte un autre collecteur (42) auquel est reliée la sortie (43) d'un circuit (41) formant miroir de courant, dont l'entrée reçoit un courant de référence ($I_o$), cet autre collecteur (42) du transistor latéral (40) formant source de courant étant en outre relié à la base de ce transistor (40) (figures 4e, 4f, 4g, 4h, 4i, 4k).

2. Logique à transistors inverses selon la revendication 1, caractérisée en ce que l'autre collecteur (42) du transistor latéral (40) formant source de courant est court-circuité avec la base (figures 4g, 4h, 4i, 4k).

3. Logique à transistors inverses selon la revendication 1, caractérisée en ce que pour relier l'autre collecteur (42) du transistor latéral (40) formant source de courant avec sa base il est prévu un transistor (44) fonctionnant comme amplificateur de courant de base, et ayant le même type de conductibilité que le transistor latéral (40) formant source de courant, l'émetteur du transistor (44) étant relié à la base du transistor latéral (40) formant source de courant et sa base étant reliée à l'autre collecteur (42) du transistor, transistor dont la base est reliée à l'autre collecteur (42) du transistor latéral (40) formant source de courant et dont le collecteur est au potentiel d'émetteur du transistor de portes (801, 802) (figures 4e, 4f) formant le potentiel de référence de la porte.

4. Logique à transistors inverses selon l'une des revendications 1 à 3, caractérisée en ce que le circuit miroir de courant (41) comporte un premier transistor (90) et un second transistor (91) qui sont tous deux du même type de conductivité que le transistor de portes (801, 802), le collecteur du premier transistor (90) étant reliée à l'entrée du circuit miroir de courant (41) et le collecteur du second transistor (91) formant la sortie (43) du circuit miroir de courant (41), l'émetteur des deux transistors (90, 91) étant mis au potentiel d'émetteur du transistor de portes (801, 802) servant de potentiel de référence de portes et la base des deux transistors (90, 91) étant reliées à l'autre et au collecteur du premier transistor (90) (figures 4e, 4f).

5. Logique à transistors inverses selon la revendication 4, caractérisée en ce que les bases des deux transistors (90, 91) du circuit formant miroir de courant (41) sont court-circuitées sur le collecteur du premier transistor (90) (figure 4e).

6. Logique à transistors inverses selon la revendication 4, caractérisée en ce que pour relier la base des deux transistors (90, 91) du circuit formant miroir de courant (41) avec le collecteur du premier transistor (90) on a prévu un troisième transistor (45) de même type de conductibilité que le transistor de portes (801, 802) et fonctionnant comme amplificateur de courant de base, transistor dont l'émetteur est relié à la base des deux transistors (90, 91), transistor dont la base est reliée au collecteur du premier transistor (90) et dont le collecteur est relié au collecteur du second transistor (91) (figure 4f).

7. Logique à transistors inverses selon l'une des revendications 1 à 3, caractérisée en ce que le circuit formant miroir de courant (41) se compose d'un seul transistor (900) de même type de conductivité que le transistor de portes (801, 802) et ayant au moins deux collecteurs dont l'un ou un premier groupe combiné de collecteurs est relié à la base de ce transistor (900) et forme l'entrée du circuit miroir de courant (41), un autre collecteur ou second groupe de collecteurs réunis de ce transistor (900) formant la sortie (43) du miroir de courant (41) et en outre l'émetteur de ce seul transistor (900) formant le circuit miroir de courant (41) étant au potentiel d'émetteur du transistor de portes (801, 802) (figures 4i, 4k) servant de potentiel de référence pour la porte.

8. Logique à transistors inverses selon l'une des revendications 4 à 7, caractérisée en ce que le premier transistor (90) et le second transistor (91) ou le seul transistor (900) du circuit miroir de courant (41) est formé par un transistor vertical à amplification ascendante.

9. Logique à transistors inverses selon l'une des revendications 1 à 8, comportant un grand nombre de transistors de portes (80; 801, 802...) verticaux amplifiant dans le sens ascendant, qui sont respectivement alimentés en courant utile par un transistor latéral (40) formant source de courant, logique caractérisée en ce que pour fournir ces courants utiles, on utilise des transistors sources de courant (40) à plusieurs collecteurs et chaque collecteur ou le grand nombre de collecteurs de ces transistors sources de courant (40) à collecteurs multiples servant respectivement à fournir le courant utile à un seul transistor de portes (80; 801, 802...) vertical, amplifiant dans le sens ascendant.

10. Logique à transistors inverses selon la revendication 9, caractérisée en ce que pour les transistors de portes (80; 801, 802...) et pour les transistors sources de courant (40) à collecteurs multiples on a prévu chaque fois des champs séparés (GF, SQ), le câblage de l'ensemble du circuit étant réalisé par des chemins conducteurs passant sur le cristal semi-conducteur en étant isolé par rapport à celui-ci, ces chemins étant en métal et/ou en une matière semi-conductrice polycristalline et/ou par des ponts (59) passant dans le cristal semi-conducteur, ponts réalisés en un matériau semi-conducteur diffusé, faiblement ohmique.

11. Logique à transistors inverses selon la revendication 10, caractérisée en ce que pour les ponts de câblage (59) passant le cristal semi-conducteur on a prévu des champs en une matière semi-conductrice, diffusée, faiblement ohmique, servant de champs de câblage (VF).

12. Logique à transistors inverses selon la revendication 10, caractérisée en ce qu'un seul transistor source de courant (40) à collecteurs multiples est logé dans un champ de transistor formant source de courant (SQ), à collecteurs multiples, et le champ de transistor formant source de courant à collecteurs multiples (SQ) forme une bande étroite, allongée, l'émetteur (52) du transistor source de courant à collecteurs multiples (40) s'étendant dans la direction longitudinale de cette bande et les collecteurs (53) étant prévus le long de cette bande d'émetteur (52) de manière équidistante.

13. Logique à transistors inverses selon la revendication 12, caractérisée en ce que les collecteurs (53) sont prévus sur l'un des deux côtés longitudinaux de la bande formant émetteur (52).

14. Logique à transistors inverses selon la revendication 12, caractérisée en ce que les collecteurs (53) sont prévus sur les deux grands côtés de la bande d'émetteur (52).

15. Logique à transistors inverses selon l'une des revendications 10 à 14, caractérisée en ce que les transistors portes (80; 801, 802...) verticaux à amplification dans le sens ascendant sont des structures rectangulaires en vue de dessus dans le champ de portes (GF), dans lesquelles sont prévus les raccords extérieurs ($B_i$, $C_1$, $C_2$, $C_3$) parallèlement aux grands côtés du rectangle.

16. Logique à transistors inverses selon l'une des revendications 9, 10, 12, 15 et selon l'une des revendications 13 et 14, logique caractérisée en ce que les grands côtés des champs de transistors (SQ) formant les sources de courant à collecteurs multiples et les grands côtés des transistors de portes (80; 801, 802,...) sont parallèles dans les champs de portes (GF).

17. Logique à transistors inverses selon les revendications 10 et 11, caractérisée en ce qu'entre un champ de portes (GF) et un champ de transistors (SQ) formant sources de courant à collecteurs multiples il est prévu un champ de câblage (VF).

18. Logique à transistors inverses selon l'une des revendications 10 à 12 et 17, caractérisée en ce que les ponts (59) passant dans le champ de câblage (VF) sont en un matériau semi-conducteur, diffusé, faiblement ohmique, généralement parallèles aux bandes étroites allongées du champ de transistors formant sources de courant (SQ) à collecteurs multiples.

19. Logique à transistors inverses selon les revendications 10 et 15, caractérisée en ce que les chemins conducteurs passant sur le cristal semi-conducteur en étant isolés par rapport à celui-ci sont en métal et/ou en un matériau semi-conducteur polycristallin en étant principalement perpendiculaires aux grands côtés des transistors de portes (80; 801, 802,...) dans le champ de portes (GF).

20. Logique à transistors inverses selon la revendication 16, caractérisée en ce qu'entre deux champs de transistors (SQ) formant sources de courant à collecteurs multiples il est prévu un seul champ de portes (GF) qui alimente en courant utile les deux champs de transistors (SQ) formant sources de courant à collecteurs multiples.

21. Logique à transistors inverses selon la revendication 20, caractérisée en ce que le champ de portes (GF) comprend entre 6 et 10 lignes de portes.

22. Logique à transistors inverses selon les revendications 7 et 8, et selon au moins l'une des revendications 10 à 21, caractérisée en ce que pour le transistor vertical unique à amplification dans le sens ascendant, formant le circuit miroir de courant (41), on a un transistor de portes (80) d'un champ de portes (GF).

# FIG. 1b

# FIG. 1a

# FIG. 1c

# FIG. 2

# FIG. 3

FIG. 4a

FIG. 4b

FIG.4c

FIG.4d

FIG.4e

FIG.4f

# FIG. 4g

# FIG. 4h

# FIG. 4i

# FIG. 4k

# FIG. 5

B_i  C_1  C_2  C_3  E  B  C

$n^+$ -2-  -2-  $n^+$  -3-  $n^+$

P

1

40, SQ   101   80

GF

FIG. 6

# FIG. 7